# EUROPEAN PATENT APPLICATION

(11) **EP 2 290 702 A1**
(43) Date of publication of application: **02.03.2011**
(21) Application number: 09753408.5
(22) Date of filing: 04.03.2009
(51) Int. Cl.: H01L 31/045, H01L 31/18

(54) **METHOD AND DEVICE FOR ASSEMBLING FILM SOLAR BATTERY SUBASSEMBLY AND PRODUCT FABRICATED THEREFROM**

(30) Priority: 28.05.2008 CN 200810110740
(71) Applicant: Advanced Technology & Materials Co., Ltd, Beijing 100081 (CN)
(72) Inventor: LU, Zhichao, Beijing 100081 (CN); FANG, Ling, Beijing 100081 (CN); ZHOU, Shaoxiong, Beijing 100081 (CN); LI, Deren, Beijing 100081 (CN); ZHU, Jingsen, Beijing 100081 (CN); LIU, Yingchun, Beijing 100081 (CN); YAN, Youhua, Beijing 100081 (CN); DENG, Junmin, Beijing 100081 (CN); ZHANG, Bo, Beijing 100081 (CN); Wang, Bing, Beijing 100081 (CN)
(74) Representative: COHAUSZ DAWIDOWICZ HANNIG & SOZIEN
(86) International application number: PCT/CN2009/000228
(87) International publication number: WO 2009/143690

(57) **Abstract**

A method of assembling film solar battery subassembly is provided,which comprising: leading and outputting lower tectorial membranes continuously to a heated conveying surface; leading and outputting multiple battery strips(16) to the lower tectorial membranes. A back surface of each battery strip is located opposite to a front surface of the battery strips. One of the battery strips is laminated with the lower tectorial membranes. The neighboring battery strips are overlapped in parallel. Conductive adhesive is dripped on an overlapped area continuously. A device for assembling film solar battery subassembly and film solar battery subassembly fabricated therefrom are provided.

## Description

### Technical Field

The present invention relates to a solar battery, particularly a method and apparatus for assembling a film solar battery assembly, and a film solar battery assembly manufactured by the method and apparatus.

### Background Art

A film solar battery mainly comprises a polycrystalline silicon or microcrystalline silicon film solar battery, an amorphous silicon film solar battery, a CdTe film solar battery, a Cu(In, Ga)(S, Se)2 film solar battery and so on. In order to reduce the manufacturing cost, a process for manufacturing large area film solar battery is needed. However, the large area film solar battery process causes the difficulty for controlling the uniformity of the product performance and increases the technical difficulty for the apparatus control.

The film solar battery is typically manufactured by a film preparing technology, i.e. sequentially preparing relevant layers of film required for the solar battery on a substrate of a large area. During the preparation of the films, the battery having a large area is slotted into small cells by mechanical cutting or laser cutting. The terminals of the cells are connected by a suitable material so as to connect the cells in the battery assembly in series, forming a complete battery assembly.

Further, if a metal strip is used as the substrate, it is necessary to provide a layer of insulating film between the substrate and the film battery, in order to provide insulation between the lower electrode of the battery and the substrate. The step of providing such an insulating film will in a certain degree increase the cost of manufacturing the battery.

US4278473 discloses a method for series connecting solar cells, in which an insulating material is used as the substrate. V-grooves are cut with certain spacing on the formed cell. The depth of the groove is less than the thickness of the insulating substrate. An insulating layer is then provided on a side of the V-groove and a conductive layer is provided on the insulating layer. One side of the conductive layer is connected to the upper electrode layer of one cell, and the other side is connected to the lower electrode layer of the adjacent cell, so that a series connection is achieve between adjacent cells. The process is characterized in that first a large area battery is formed and then divided into small unit cells so as to perform series connecting. The process can provide a high working voltage. However, it is difficult to control the uniformity of the battery performance due to the large area preparation.

Instead of the physical dividing method, the cells can otherwise be divided. US 4173496 discloses a method for connecting solar cell modules. Instead of the slotting method for dividing the solar cells, material modification is used for alter the PN junction of a fixing region into an electrical insulation region, so as to achieve the isolation of the cells. The material for series connecting the cells can be the original electrode material of the battery or other conductive paste. It is also difficult for such a method to control the uniformity of the battery performance due to the large area preparation.

US5266125 discloses a connection for a polycrystalline silicon film solar battery assembly, in which an insulating ceramic material is used as the substrate. The small unit cells are divided by vertical trenches. The series connection between the cells is achieved by contacting the upper surface electrode material with the lower electrode. It is also difficult for such a method to control the uniformity of the battery performance due to the large area preparation.

US4131123 discloses a method for packaging a silicon solar cell assembly. The cell is packaged between two layers of insulating material. The terminals of the adjacent cells are lead out by printing a conductive coating and then connected with each other, so as to achieve the series connection between the submodules. It is also difficult for such a method to control the uniformity of the battery performance due to the large area preparation.

### Summary of the Invention

An object of the invention is to provide a method and apparatus for continuous assembling a film solar battery assembly in a roll-to-roll manner. Manufacturing the film solar battery assembly by use of the method and apparatus of the invention, it is possible to eliminate the requirement of forming a large area film during the manufacturing. The battery can be made on a narrower base strip. The method of manufacturing the battery assembly has the advantages of an unlimited length of battery assembly, a high reliability of connection, a high productivity, a stable quality and an easy operation.

Instead of the conventional method for irreproducible manufacturing a solar battery assembly having a large area, in the method for manufacturing a film solar battery assembly according to the invention, unit cells having a small area are prepared and then spliced into a larger battery assembly. That is to say, a film solar battery assembly is continuously prepared on a narrow strip substrate. When the width of the battery strip meets the requirement of light collecting, the grooves containing lead wires for series connection or the collecting grids will not be needed within the battery strip. The battery strip itself is a basic unit cell. Then, a sheet of battery assembly is formed by overlapping the edges of the parallel strips. Conductive glue is used for the series connection between the battery strips. The lengthening of the battery sheet in the longitudinal direction can increase the effective current of the battery assembly and can be considered as a parallel connection of the battery assembly. Thus, the sheet assembled by battery strips in series connection will be a complete batter assembly. The number of the battery strips may be selected so as to satisfy the voltage requirement depending on the desired electrical performance of the battery assembly. Also, the number of the battery strips may be selected so as to satisfy the electrical current requirement depending on the desired electrical performance of the battery assembly. In order to obtain a larger solar battery assembly, several battery sheets with assembled strips may be connected simply by leads so as to form a larger assembly. Thus, a larger solar battery assembly can be obtained by a method of splicing the battery strips and an apparatus for producing narrower battery strips. As a result, the technical requirement for an apparatus for producing a large and uniform battery is reduced, the uniformity of the battery performance is improved, and the apparatus investment is reduced. In practical, since the lengthening of the battery sheet in the longitudinal direction can be considered as a parallel connection of the battery assembly, the main function of the apparatus is to achieve the series connection between the strips.

In order to improve the efficiency, a plurality of battery strips are fed simultaneously, glue is dotted at multiple locations simultaneously, and the splicing is performed simultaneously. The number of the battery strips may be determined according to the desired voltage range of the battery assembly. The apparatus may be designed with reserved take-off positions and take-up spaces for the battery strips.

According to the invention, a method for assembling a film solar battery assembly is provided, comprising: guiding and continuously feeding a lower film onto a conveying surface which can be heated; guiding and successively feeding a plurality of battery strips onto the conveying lower film, each battery strip having a face side and a back side opposite to the face side, wherein the first battery strip and the lower film is first pressed together and then every two adjacent battery strips are overlapped in parallel; continuously dispensing conductive glue to the overlapping area of the battery strips; pressing the battery strips after overlapping the adjacent battery strips so that the battery strip and the one adjacent thereto and the battery strips and the lower film are pressed together; and winding an assembly of the battery strips and the lower film.

According to the invention, an apparatus for assembling a film solar battery assembly is also provideded, comprising: a conveying surface which may be heated; a lower film coil, which continuously feeds a lower film via a lower film guide roll onto the heated conveying surface; a plurality of battery strip coils, which are fixed on a fixing panel and positioned with equal spacing above the conveying surface in the conveying direction, wherein the battery strips are fed onto the lower film via battery strip guide rolls fixed on the fixing panel, and wherein each battery strip has a face side and a back side opposite to the face side; a plurality of glue dispensers for continuously dot-dispensing conductive glue to the battery strips, each glue dispenser being fixed on the fixing panel and positioned following the respective battery strip guide roll, the battery strip coils other than the one most downstream in the advancing direction having a respective glue dispenser arranged below them; a plurality of pressing mechanisms, each pressing mechanism being fixed on the fixing panel and positioned below a respective battery strip coil, and the respective pressing mechanism other than the one below the battery strip coil most downstream in the advancing direction being located between a glue dispenser and a battery strip guide roll; a winding mechanism being located at an outlet side downstream in the advancing direction, for taking up an assembly of the battery strips and the lower film, characterized in that: each battery strip coil protrudes a distance from the fixing panel which is different from the protruding distance of the adjacent battery strip coil, and the protruding distance difference between adjacent battery strip coils is the same and smaller than the width of one battery strip, such that the battery strips fed onto the lower film overlap with each other in parallel; on the other hand, each glue dispenser protrudes a further distance from the fixing panel so as to dot-dispensing the conductive glue to the overlapping area of the battery strips.

According to a preferred embodiment, the pressing mechnism comprises a pressure roll. Other suitable pressing mechanisms are also possible.

In the solar battery assembly manufactured by the method and apparatus according to the invention, the number of the battery strips to be series connected may be set according to the determined open-circuit voltage. The method of the invention is a continuous roll-to-roll manufacturing method. Thus, the length of the battery assembly can continously extend, can reach 1000m or more, and can be cut to meet the user's requirement. The usual width of the battery assembly can be set as a standard of a battery assembly. If it is required to increase the size (voltage or current) of the battery assembly, the standard battery strip may be connected with an external lead wire. In order to adapt to various environmental requirements, the assembled battery assembly may be vacuum or nonvacuum packaged by a covering film.

### Brief Description of Drawings

The features and advantages of the invention will be better understood with reference to the drawings, wherein:
Fig. 1 is a schematic front view showing an apparatus for assembling a film solar battery assembly according to the invention;
Fig. 2 is a schematic left view showing an apparatus for assembling a film solar battery assembly according to the invention, wherein for the sake of simplicity and clarity, only two battery strip coils and one glue dispenser are shown and a winder control cabinet is omitted;
Fig. 3 is an enlarged top view showing the overlapped battery strips in the film solar battery assembly according to the invention, wherein P designates glue dispensing spots, XM designates a lower film, TD1 designates the first battery strip, and TD2 designates the second battery strip;
Fig. 4 is an enlarged schematic side view showing the overlapped edges of the series connected battery strips in the film solar battery assembly according to the invention, wherein SM designates an upper film, TD designates the battery strip, and P designates glue dispensing spots;
Fig. 5 schematically shows the constitution of the battery strip used in the invention; and

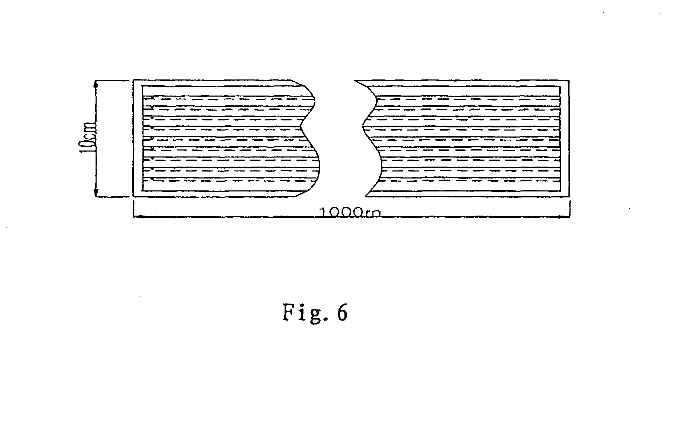

Fig. 6 schematically shows an example of the end product of the battery assembly according to the inveiton.

### Detailed description of the invention

The splicing method and apparatus for assembling the film solar battery assembly according to the invention will be described in detail hereinafter with reference to the embodiments.

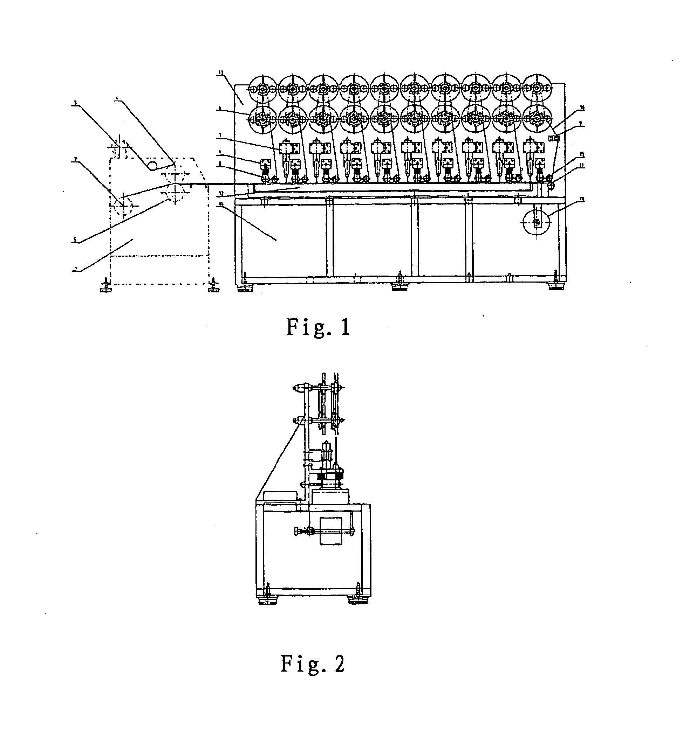

The apparatus of the invention is shown in Fig. 1. A lower film is continuously fed from a lower film coil 10. The lower film is fed, via a lower film guide roll 11, onto the surface of a heated plate 12 supported on a frame 14, and is advanced on the surface of the plate 12. During the advancing of the lower film, the plate 12 is heated to a temperature e.g. 120°C which then maintains constant. According to the invention, the lower film can be a precoated film, wherein one side of it is coated with glue and the uncoated side comes into direct contact with the heated plate 12. Alternatively, the lower film can be in the form of a multi-layered film, e.g. a composite film formed by a layer of glue film and one or more layers of plastic film. The temperature of the heated plate can melt the precoated glue or the glue film, while the lower film will not adhere to the heated plate so as to continuously advance.

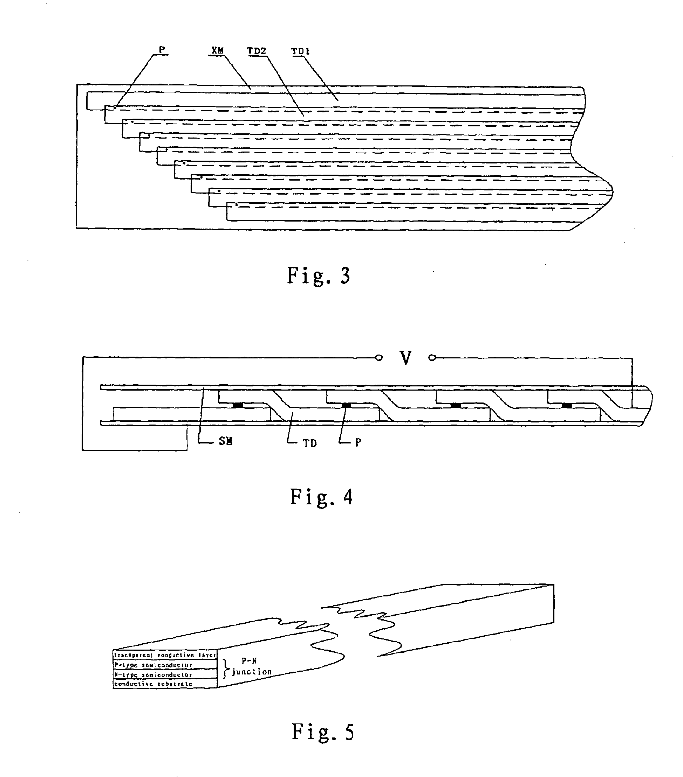

In the embodiment as shown in Fig. 1, above the heated plate 12, ten battery strip coils 6, adjacent to each other and equidistant, are mounted on the fixing panel 13 by bearings. The position of the battery strip coils 6 may be at the same level, or may be staggered without interfering with the conveyance of the battery strips. According to the invention, the number of the battery strip coils 6 may be other than ten. The position and number of the battery strip coils may be increased or decreased depending on the number of the battery strips desired to be connected in series. In the case where no lead wire strip (which will be described hereinafter) will be used, there will be at least two battery strip coils. In the embodiment as shown in Fig. 1, in the advancing direction of the lower film on the heated plate, the first to tenth battery strip coil 6 are successively arranged from upstream to downstream. As shown in Fig. 2, every battery strip coil 6 protrudes from the fixing panel 13 more than the preceding one, while the protruding difference between adjacent battery strip coils is the same and smaller than the width of one battery strip. Battery strip guide rolls 15 are fixed on the fixing panel 13. Each battery strip guide roll 15 corresponds to a battery strip coil 6. The battery strip guide rolls 15 are positioned below the battery strip coils 6 and close to the heated plate. In the case where the battery strip coils 6 are at the same level, the battery strip guide rolls 15 are also at the same level. In this manner, battery strips 16 are continuously and successively fed from the battery strip coils 6 onto the lower film continuously advancing on the heated plate 12 via the battery strip guide rolls 15, such that the adjacent battery strips fed out are in parallel with each other and overlap at the edges thereof, wherein the overlapping amount of every two adjacent battery strips is equal. Specifically, the face side of each battery strip fed onto the lower film is oriented downwards, and the back side of each preceding battery strip overlaps with the face side of the next one adjacent thereto. As shown in Fig. 5, a battery strip comprises a transparent conductive layer, a P-type semiconductor layer, a N-type semiconductor layer and a conductive substrate layer. The face side of the strip is a side on which the transparent conductive layer is located, and the back side of the strip is a side on which the conductive substrate layer is located.

Below the battery strip coils 6, nine glue dispensers 7 are fixed on the fixing panel 13. As shown in Fig. 1, only the last (i.e. the tenth) battery strip coil has no glue dispenser arranged below it. Each glue dispenser is at the same height from the surface of the heated plate. However, the protruding difference between each two adjacent glue dispensers protruded from the fixing panel corresponds to that of the battery strip coils as mentioned above, such that each glue dispenser can precisely dispense the glue to the overlapping area of adjacent battery strips. The conductive glue is filled into a conductive glue tube in advance. The glue dispensers 7 continuously dispense the conductive glue to the overlapping area of the battery strips. The diameter of the needle of the glue dispenser is 0.2-0.8 mm, preferably 0.4 mm. The dispensing pressure may be e.g. 0.4 MPa. By stationary glue dispensing, the glue dispensing spots of the glue dispenser maintains stationary during the advancing of the battery strips, so as to ensure a uniform line of the conductive glue.

On the fixing panel 13 are also fixed ten pressure rolls 8, each of which is located between the glue dispenser 7 and the battery strip guide roll 15 and close to each other. The pressure rolls are continuously rotated and maintain a suitable spacing from the surface of the heated plate, such that the battery strips can be pressed together with each other and with the lower film. Here, note that since the last battery strip coil 6 has no glue dispenser arranged below it, the pressure roll 8 below the last battery strip coil 6 is only adjacent to and downstream from a corresponding battery strip guide roll 15. Further, since the width of the battery strip and that of the overlapping area of the battery strips are much smaller with respect to the width of the pressure roll 8, the pressure rolls 8 may protrude the same distance from the fixing panel, as long as each battery strip and the overlapping area of each two battery strips are all within the width of the pressure roll body.

When the first battery strip is fed onto the lower film via the guide roll 15, it first passes under the pressure roll corresponding to the first battery strip coil. Since the glue of the precoated side of the lower film (or the layer of glue film) is melted under the temperature of the heated plate, the battery strip is pressed and thus sealed to the lower film by the pressure roll. Then, the glue dispenser corresponding to the first battery strip coil begins to dispense the glue and will continuously dispense the glue thereafter. Subsequently, when the lower film carrying the first battery strip passes under the battery strip guide roll corresponding to the second battery strip coil, the second battery strip is fed out, and the face side thereof overlaps with the back side of the first battery strip dotted with the conductive glue; and then the second battery strip passes under the pressure roll corresponding to the second battery strip coil, so that the second battery strip is pressed and sealed to the first battery strip and the lower film. The thus formed assembly then arrives at the glue dispenser corresponding to the second battery strip coil, which dispenses the glue to the edge of the second battery strip to be overlapped with the next battery strip, and so on. Then, in the overlapping area of each two adjacent battery strips, the conductive glue is used for joining the back side of the preceding battery strip and the face side of the next one adjacent thereto which then pressed together by the pressure roll, so as to achieve the series connecting of the battery strips. The glue dispensing spots and the overlapping of the battery strips are shown in Figs. 3 and 4.

According to the invention, the battery strip 16 is advanced only along its length, while the position in the width and thickness direction maintains relatively stationary by the constraint of the pressure roll. The heated plate 12 may be heated by heat conduction oil or other suitable manners, so as to bring the lower film and the battery strip glued together and further facilitate the precise control of the glue dispensing spots and the relative position of the battery strips, thereby reducing the fluctuation of the relative position of the battery strips during the advancing. A take-up spindle is arranged above each battery strip coil 6 and rotated by a belt, so as to withdraw the spacer lining material of the battery strip coil. The overlapping size of adjacent battery strip coils may be controlled by adjusting the position of the battery strip guide roll15. The overlapping width is 0.5-2.5 mm, preferably 0.85 mm. Since the battery strip guide roll 15 is stationary during the advancing of the battery strip, the overlapping size of the battery strips can be precisely controlled.

At the outlet side of the assembly of the lower film and the battery strip, a winder control cabinet 1 is positioned outside the frame 14. In the cabinet 1 are provided a pair of upper pressing roller 4 and lower pressing roller 5, at least one of which may have the heating function, and a winding spindle 2. In addition, an upper film coil 3 is provided on the cabinet 1. The upper film fed by the upper film coil 3 is wound on the upper pressing roller 4 via a guide roll and fed onto the assembly of the battery strip and the lower film fed from upstream. According to the invention, the upper film may be in the form of a single layer of film or a multi-layered film. The take-up spindle is driven by a servo motor and has a predetermined linear speed of e.g. 3 cm/s. The pneumatic pressure is activated and clamps the upper and lower pressing rollers together. Then, the assembly of the upper and lower film and the battery strip passes through the nip of the upper and lower pressing rollers and is tightly combined together. In this process, the upper and lower pressing rollers may perform the cold pressing or hot pressing. In the case of hot pressing, the upper and/or lower pressing roller may be heated to a temperature, e.g. 120°C which then maintains constant. The combined upper film, lower film and battery strip are taken up by the take-up spindle 2. Thus, a solar battery assembly is packaged with a good environment protection.

Further, according to the invention, both the upper film coil and the lower film coil can be one or more, so that it is possible to provide multiple layers of upper film and lower film. The battery strip is detected and feedback controlled by a speed sensor 9, so as to achieve the stability of the manufacturing of the solar battery assembly. The control system of the apparatus makes use of a PLC control system, an image pickup and analyzing system and a touch screen interaction system, having an advantage of easy and automated control.

The end product (i.e. the film solar battery assembly) made by the method and apparatus described in the above embodiment has a width of 10 cm, an open-circuit voltage of 5.5 V and an unlimited length, e.g. 1000 m or more. The width of the end product depends on the number of the spliced battery strips. For example, when the battery assembly has only one battery strip, the width of the end product may be 1 cm; when a battery assembly comprising thirty battery strips is made, the width of the end product may be 30 cm. Any desired length can be cut according to the user's requirement so as to satisfy the current required for the battery assembly. If a higher working voltage is needed, the battery assembly can be connected in series by metal wires.

Further, if desired, a lead wire strip coil may be used for replacing the first or last battery strip coil. In the case where a lead wire strip coil replaces the first battery strip coil, the lead wire strip is first pressed and sealed to the lower film by the first pressure roll. The battery strips fed from the subsequent battery strip coils are oriented with the face side downwards. Two terminal lead wires of the battery assembly are connected to the lead wire strip and the last battery strip, respectively. In the case where a lead wire strip coil replaces the last battery strip coil, as mentioned above, the battery strips fed from the successive battery strip coils are oriented with the face side upwards. In such a case, two terminal lead wires of the battery assembly are connected to the first battery strip and the lead wire strip, respectively. In the case where a lead wire strip is used, there will be at least one battery strip coils.

By using the assembling method and apparatus of the film solar battery assembly according to the invention, the film solar battery assembly can be manufactured in a continuous, efficient and easy manner. The continuous manufacturing of the film solar battery assembly can be performed by the series connecting of the battery strips achieved by the edge overlapping. The voltage of the film solar battery assembly may be determined as desired. The manufacturing is performed on the same apparatus, so that the width and length of the film solar battery assembly may be adjusted at discretion. The method and apparatus according to the invention avoid the disadvantages caused by the pre-embedded terminal and have a low cost.

## Claims

1. A method for assembling a film solar battery assembly, comprising:
guiding and continuously feeding a lower film onto a conveying surface which can be heated;
guiding and successively feeding a plurality of battery strips onto the conveying lower film, each battery strip having a face side and a back side opposite to the face side, wherein the first battery strip and the lower film is first pressed together and then every two adjacent battery strips are overlapped in parallel;
continuously dispensing conductive glue to the overlapping area of the battery strips;
pressing the battery strips after overlapping the adjacent battery strips so that the battery strip and the one adjacent thereto and the battery strips and the lower film are pressed together; and
winding an assembly of the battery strips and the lower film.

2. The method according to claim 1, wherein the battery strips and the lower film are moved only in the conveying direction during the conveying thereof.

3. The method according to claim 1, wherein the dispensing spots of the conductive glue are held stationary.

4. The method according to claim 1, wherein a lead wire strip may be fed before the first battery strip is fed or after the last battery strip is fed.

5. The method according to any one of claims 1-4, wherein the assembly of the battery strips and the lower film is packaged by an upper film before being wound.

6. The method according to claim 5, wherein both the upper film and the lower film may be in the form of a single layer of film or a multi-layered composite film.

7. An apparatus for assembling a film solar battery assembly, comprising:
a conveying surface which may be heated;
a lower film coil, which continuously feeds a lower film via a lower film guide roll onto the heated conveying surface;
a plurality of battery strip coils, which are fixed on a fixing panel and positioned with equal spacing above the conveying surface in the conveying direction, wherein the battery strips are fed onto the lower film via battery strip guide rolls fixed on the fixing panel, and wherein each battery strip has a face side and a back side opposite to the face side;
a plurality of glue dispensers for continuously dot-dispensing conductive glue to the battery strips, each glue dispenser being fixed on the fixing panel and positioned following the respective battery strip guide roll, the battery strip coils other than the one most downstream in the advancing direction having a respective glue dispenser arranged below them;
a plurality of pressing mechanisms, each pressing mechanism being fixed on the fixing panel and positioned below a respective battery strip coil, and the respective pressing mechanism other than the one below the battery strip coil most downstream in the advancing direction being located between a glue dispenser and a battery strip guide roll;
a winding mechanism being located at an outlet side downstream in the advancing direction, for taking up an assembly of the battery strips and the lower film,
**characterized in that**:
each battery strip coil protrudes a distance from the fixing panel which is different from the protruding distance of the adjacent battery strip coil, and the protruding distance difference between adjacent battery strip coils is the same and smaller than the width of one battery strip, such that the battery strips fed onto the lower film overlap with each other in parallel; on the other hand, each glue dispenser protrudes a further distance from the fixing panel so as to dot-dispensing the conductive glue to the overlapping area of the battery strips.

8. The apparatus according to claim 7, wherein a lead wire strip coil is positioned before or after the plurality of battery strips in the advancing direction.

9. The apparatus according to claim 7, wherein the winding mechanism is provided therein with an upper film coil, which feeds the upper film via an upper film guide roll onto the assembly of the battery strips and the lower film, and a pressing mechanism for packaging the upper film and the assembly.

10. The apparatus according to claim 7, wherein the plurality of battery strip coils are positioned at the same level or staggered.

11. The apparatus according to claim 7, wherein the battery strip guide rolls are adjustable so as to adjust the size of the overlapping area of the battery strips.

12. The apparatus according to claim 9, wherein both the upper film and the lower film may be in the form of a single layer of film or a multi-layered composite film.

13. An film solar battery assembly manufactured by the apparatus according to claim 7, wherein the film solar battery assembly has a width of 1-30 cm and a continuous length.
